# EUROPEAN PATENT APPLICATION

(11) **EP 4 800 921 A1**
(43) Date of publication of application: **02.09.2026**
(21) Application number: 25305268.2
(22) Date of filing: 28.02.2025
(51) Int. Cl.: H03B 19/14

(54) **FREQUENCY DOUBLER CIRCUIT**

(71) Applicant: NXP B.V., 5656 AG Eindhoven (NL)
(72) Inventor: CILICI, Florent Jérémy Alexis, 31023 Toulouse (FR); THURIÉS, Stephane Damien, 31600 Toulouse (FR); OLIEMAN, Erik, 5656 AE Eindhoven (NL)
(74) Representative: Schwarzweller, Thomas

(57) **Abstract**

The disclosure relates to a frequency doubler circuit (100) comprising: first and second input terminals (101, 102) for receiving an input voltage signal (IN+, IN-) at a first frequency; a first pair of transistors (103a, 103b) connected between a supply line (104) and a first node (105); a second pair of transistors (106a, 106b) connected between a common line (107) and a second node (108), the first and second pairs of transistors (103a, 103b, 106a, 106b) having gates coupled to the respective first and second input terminals (101, 102); an output matching circuit (109) having first and second output terminals (110, 111) for providing an output voltage signal (OUT+, OUT-) at a second frequency; a first common gate transistor (112) connected between the first node (105) and a first input (113) of the output matching circuit (109); and a second common gate transistor (114) connected between the second node (108) and a second input (115) of the output matching circuit (109).

## Description

### Field

The disclosure relates to a frequency doubler circuit and a method of operating a frequency doubler circuit.

### Background

A frequency multiplier is an electronic circuit that uses nonlinear components to generate an output signal having a frequency that is a harmonic of an input signal, thereby multiplying the frequency of the input signal. A subsequent bandpass filter can be used to select a desired harmonic and remove other unwanted harmonics. Frequency multipliers may be used for example in synthesizers and communications circuits. In high frequency, for example RF applications, frequency multipliers can be more effective at generating a desired frequency of an output signal than by generating the output signal directly.

A common type of frequency multiplier is a frequency doubler, which outputs a signal that is twice the frequency of the input signal. In CMOS technology, a push-pull architecture is one way to increase the efficiency of such circuits.

### Summary

According to a first aspect there is provided a frequency doubler circuit comprising: first and second input terminals for receiving an input voltage signal at a first frequency; a first pair of transistors connected between a supply line and a first node, the first pair of transistors having gates AC coupled to the respective first and second input terminals; a second pair of transistors connected between a common line and a second node, the second pair of transistors having gates AC coupled to the respective first and second input terminals; an output matching circuit having first and second output terminals for providing an output voltage signal at a second frequency; an amplifier having a first input connected to the output matching circuit, a second input connected to a target voltage input and an output connected to provide a bias voltage to the gates of the first or second pairs of transistors; a first common gate transistor connected between the first node and a first input of the output matching circuit; and a second common gate transistor connected between the second node and a second input of the output matching circuit.

The first pair of transistors may comprise first and second p-channel MOSFETs, a drain of the first p-channel MOSFET connected to a drain of the second p-channel MOSFET and a source of the first p-channel MOSFET connected to a source of the second p-channel MOSFET. The drains of the first pair of transistors may be connected to the first node and the sources of the first pair of transistors may be connected to the supply line.

The first common gate transistor may be a third p-channel MOSFET having a gate connected to a first common gate signal input.

The second pair of transistors may comprise first and second n-channel MOSFETs, a drain of the first n-channel MOSFET connected to a drain of the second n-channel MOSFET and a source of the first n-channel MOSFET connected to a source of the second n-channel MOSFET.

The drains of the second pair of transistors may be connected to the second node and the sources of the second pair of transistors may be connected to the common line.

The second common gate transistor may be a third n-channel MOSFET having a gate connected to a second common gate signal input.

The output matching circuit may comprise a transformer having a centre tap connected between the first and second inputs of the output matching circuit.

The first input of the amplifier may be connected to the centre tap and the output of the amplifier connected to provide the bias voltage to the gates of the first pair of transistors via respective first and second biasing resistors.

The first input of the amplifier may be connected to the centre tap and the output of the amplifier connected to provide a bias voltage to the gates of the second pair of transistors via respective first and second biasing resistors.

The frequency doubler circuit may comprise a bias voltage input connected to provide a bias voltage to the gates of the second pair of transistors via respective third and fourth biasing resistors.

The frequency doubler circuit may comprise a bias voltage input connected to provide a bias voltage to the gates of the first pair of transistors via respective third and fourth biasing resistors.

The gates of the first pair of transistors and the gates of the second pair of transistors may be each AC coupled to the respective first and second input terminals via a capacitor or a transformer.

According to a second aspect there is provided a method of operating a frequency doubler circuit, the frequency doubler circuit comprising: first and second input terminals for receiving an input voltage signal at a first frequency; a first pair of transistors connected between a supply line and a first node, the first pair of transistors having gates AC coupled to the respective first and second input terminals; a second pair of transistors connected between a common line and a second node, the second pair of transistors having gates AC coupled to the respective first and second input terminals; an output matching circuit having first and second output terminals for providing an output voltage signal at a second frequency; an amplifier having a first input connected to the output matching circuit, a second input connected to a target voltage input and an output connected to provide a bias voltage to the gates of the first or second pairs of transistors; a first common gate transistor connected between the first node and a first input of the output matching circuit; and a second common gate transistor connected between the second node and a second input of the output matching circuit, the method comprising: providing an input voltage signal at the first frequency at the first and second input terminals; providing bias voltage signals to the gates of the first and second pairs of transistors and the gates of the first and second common gate transistors; and providing an output voltage signal at the first and second output terminals at a second frequency double the first frequency.

The output matching circuit may comprises a transformer having a centre tap connected between the first and second inputs of the output matching circuit, the first input of the amplifier is connected to the centre tap and the output of the amplifier is connected to provide the bias voltage to the gates of the first or second pairs of transistors via respective biasing resistors, the method comprising providing the target voltage to the second input of the operational amplifier. The target voltage may be half that of a supply voltage provided at the supply line.

Other features of the circuit according to the first aspect may also be applied to the second aspect.

These and other aspects of the invention will be apparent from, and elucidated with reference to, the embodiments described hereinafter.

### Brief description of Drawings

Embodiments will be described, by way of example only, with reference to the drawings, in which:
Figure 1 is a schematic circuit diagram of an example frequency doubler circuit;
Figure 2 is a plot of simulated voltage signals in the frequency doubler circuit of Figure 1;
Figure 3 is a plot of simulated input and output voltage signals in the frequency doubler circuit;
Figure 4 is a plot of simulated differential voltage outputs as a function of frequency;
Figure 5 is a plot of common voltage outputs as a function of frequency;
Figure 6 is a plot of simulated bias currents as a function of frequency; and
Figure 7 is a plot of simulated common mode outputs as a function of frequency.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

Disclosed herein is a push-pull frequency doubler circuit that is able to achieve a high design yield and a high-power efficiency. The frequency doubler circuit employs an internal feedback loop to reduce common mode harmonics.

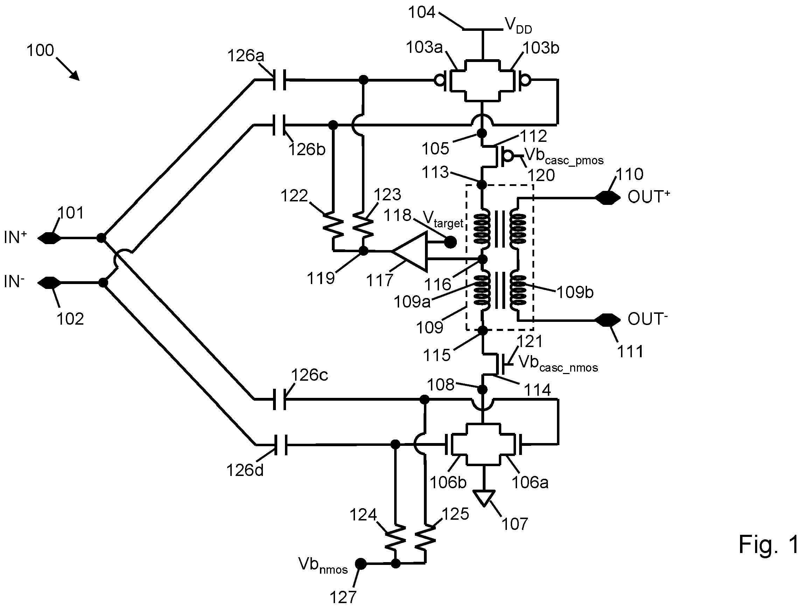

Figure 1 illustrates an example frequency doubler circuit 100, in which the frequency doubling operation is achieved by first and second pairs of common source transistors. A complementary (NMOS-PMOS) push-pull structure is used to increase the power efficiency of the circuit. Common gate transistors are connected in series with the first and second pairs of common source transistors to further increase the gain and output impedance, thus increasing the power efficiency of the circuit.

The frequency doubler circuit 100 comprises first and second input terminals 101, 102 for receiving a differential input voltage signal IN+, IN- at a first frequency. The circuit 100 provides a differential output voltage signal OUT+, OUT- at first and second output terminals 110, 111. The output voltage signal has a frequency that is twice the first frequency.

A first pair of transistors 103a, 103b is connected between a supply line 104 providing a supply voltage V_{DD} and a first node 105. The first pair of transistors 103a, 103b have gates that are AC coupled to the first and second input terminals 101, 102. In the circuit illustrated in Figure 1, a first transistor 103a of the first pair of transistors has a gate that is AC coupled to the first input terminal 101 via a first capacitor 126a. A second transistor 103b of the first pair of transistors has a gate that is AC coupled to the second input terminal 102 via a second capacitor 126b. In alternative arrangements, the gates of the first and second pairs of transistors may be AC coupled to the first and second input terminals via a transformer with two secondary coils, with a voltage bias connected to a centre tap of the transformer.

A second pair of transistors 106a, 106b is connected between a common line 107 and a second node 108. The second pair of transistors 106a, 106b have gates that are also coupled to the first and second input terminals 101, 102. A first transistor 106a of the second pair of transistors has a gate that is AC coupled to the first input terminal 101 via a third capacitor 126c. A second transistor 106b of the second pair of transistors has a gate that is AC coupled to the second input terminal 102 via a fourth capacitor 126d.

The circuit 100 comprises an output matching circuit 109 having first and second output terminals 110, 111 for providing the differential output voltage signal OUT+, OUT- at the second frequency.

A first common gate transistor 112 is connected between the first node 105 and a first input 113 of the output matching circuit 109. A second common gate transistor 114 is connected between the second node 108 and a second input 115 of the output matching circuit 109. The first common gate transistor 112 has a gate that is connected to a first common gate signal input 120, at which a first common gate voltage signal Vb_{casc_pmos} is provided. A source of the first common gate transistor 112 is connected to the first node 105 and a drain of the first common gate transistor 112 is connected to the first input 113 of the output matching circuit 109. The second common gate transistor 114 has a gate that is connected to a second common gate signal input 120, at which a second common gate voltage signal Vb_{casc_nmos} is provided. A source of the second common gate transistor 114 is connected to the second node 108 and a drain of the second common gate transistor 114 is connected to the second input 115 of the output matching circuit 109.

In the illustrated example in Figure 1, the first pair of transistors 103a, 103b comprise first and second p-channel MOSFETs. The first and second p-channel MOSFETs 103a, 103b have drains and sources that are connected together, i.e. a drain of the first p-channel MOSFET 103a is connected to a drain of the second p-channel MOSFET 103b and a source of the first p-channel MOSFET 103a is connected to a source of the second p-channel MOSFET 103b. The drains of the first pair of transistors 103a, 103b are connected to the first node 105 and the sources of the first pair of transistors 103a, 103b are connected to the supply line 104. Correspondingly, the second pair of transistors 106a, 106b comprise first and second n-channel MOSFETs. The first and second n-channel MOSFETs 106a, 106b have drains and sources that are connected together, i.e. a drain of the first n-channel MOSFET 106a is connected to a drain of the second n-channel MOSFET 106b and a source of the first n-channel MOSFET 106a is connected to a source of the second n-channel MOSFET 106b. The drains of the second pair of transistors 106a, 106b are connected to the second node 108 and the sources of the second pair of transistors 106a, 106b are connected to the common line (or ground) 107.

The output matching circuit 109 comprises a transformer having first and second windings 109a, 109b, a centre tap 116 on the first winding 109a being connected between the first and second inputs 113, 115 of the output matching circuit 109. The centre tap 116 is connected to a first input of an amplifier 117. A second input of the amplifier 117 is connected to a target voltage input 118. A target voltage V_{target} provided at the second input 118 may be half the supply voltage at the supply line 104, i.e. V_{DD}/2. An output 119 of the amplifier 117 is connected to provide a bias voltage to the gates of the first pair of transistors 103a, 103b via respective first and second biasing resistors 122, 123. In alternative examples, the output 119 of the amplifier 117 may be connected to provide the bias voltage to the gates of the second pair of transistors 106a, 106b. In other alternative arrangements, the first input of the amplifier 117 may be connected via resistors to the inputs 113, 115 of the output matching circuit 109. The amplifier 117 operates as an error amplifier and may be implemented in the form of an operational amplifier as shown in Figure 1 or in the form of another kind of circuit operable to amplify a difference between the first and second inputs, such as a differential pair with a limited gain.

A bias voltage input 127 is connected to provide a bias voltage Vbₙₘₒₛ to the gates of the second pair of transistors 106a, 106b via respective third and fourth biasing resistors 124, 125. In alternative examples, the bias voltage input 127 may be connected to provide the bias voltage to the gates of the first pair of transistors 103a, 103b.

The capacitors 126a-d provide isolation of the bias voltages applied to the first and second pairs of transistors 103a, 103b, 106a, 106b, while allowing the AC differential input voltage signal IN+, IN- to be provided to the gates of the first and second pairs of transistors 103a, 103b, 106a, 106b.

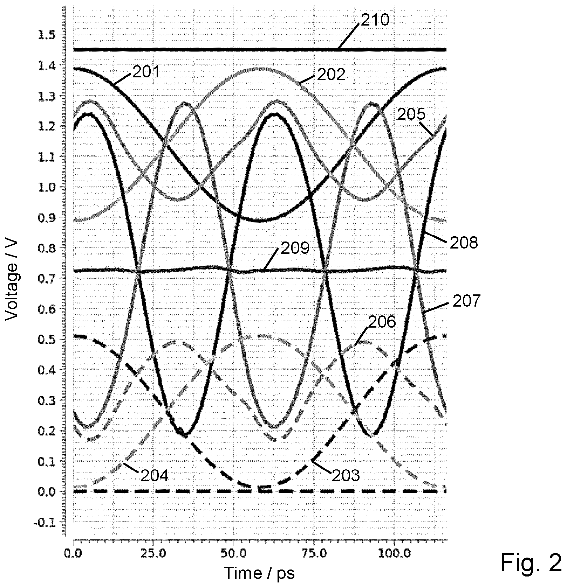

Figure 2 is a plot illustrating various simulated voltage signals at points in the circuit 100 of Figure 1, in which an input voltage signal at a frequency of 8.5 GHz is doubled to an output voltage signal at a frequency of 17 GHz by the frequency doubler circuit 100. The differential input voltage signal provided to the gates of the first pair of transistors 103a, 103b, offset by the applied bias voltage from the amplifier 117, is indicated by voltage signals 201 and 202. The differential input voltage signal provided to the gates of the second pair of transistors 106a, 106b, offset by the bias voltage Vbₙₘₒₛ, is indicated by signals 203 and 204. Voltage signal 205 indicates the voltage at the first node 105. Voltage signal 206 indicates the voltage at the second node 108. Both voltage signals 205, 206 are at twice the frequency of the input signals 201, 202 and 203, 204 due to the nonlinear response of the first and second pairs of transistors 103a, 103b, 106a, 106b. The voltages 207, 208 at the inputs 113, 115 of the output matching circuit 109 are more uniform sinusoidal waveforms due to operation of the common gate transistors 112, 114. The voltage signal 209 at the centre tap 116 of the output matching circuit 109 provides a feedback signal to maintain the voltage signal 207 around half the supply voltage V_{DD} 210, which in this example is at around 1.45 V. The target voltage V_{target} provided to the first input of the amplifier 117 is therefore set to 0.725 V.

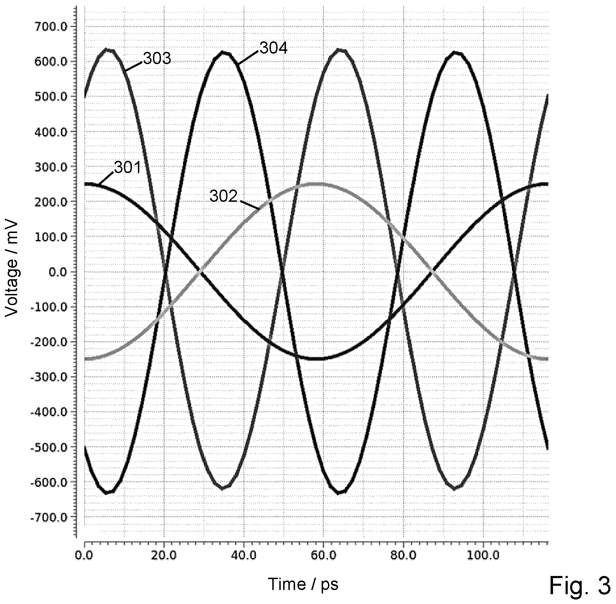

Figure 3 is a further plot illustrating the input voltages IN+ 301 and IN- 302 at the first and second input terminals 101, 102 together with the output voltages OUT+ 303, OUT- 304 at the first and second output terminals 110, 111.

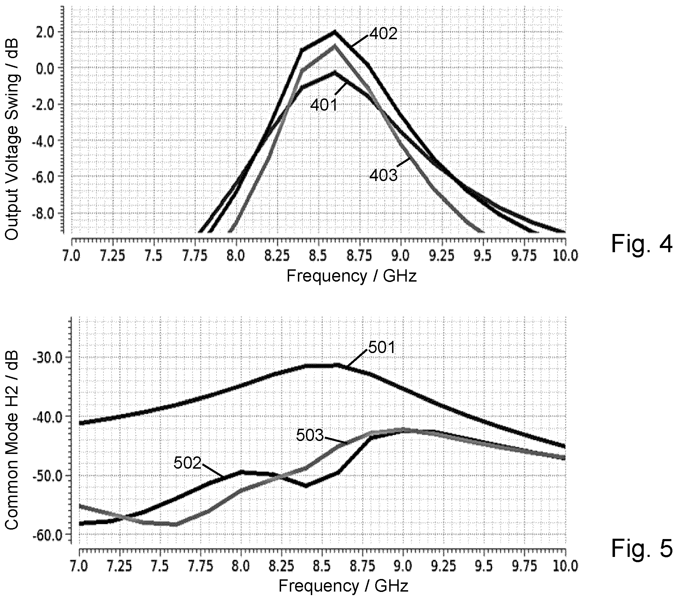

Figures 4, 5, 6 and 7 illustrate further simulation results of the frequency doubler circuit 100 showing a higher output swing compared to a conventional common source push-pull design of frequency doubler circuit. Figure 4 illustrates plots of output voltage swing in dB as a function of frequency for three different example circuits. A first plot 401 is for a conventional common source frequency doubler.

A second plot 402 is for a frequency doubler of the type disclosed herein with similar biasing in each of the common gate transistors. A third plot 403 is for a frequency doubler of the type disclosed herein with different cascode biasing.

This demonstrates around a +2 dB improvement using similar cascode biasing over the conventional frequency doubler. The output resistance in this example is 800 Ω, compared to 400 Ω for the conventional common source arrangement.

For a given output voltage swing, the doubler according to the present disclosure displays a reduced DC power. The doubler also displays significantly lower common mode H2, as shown in Figure 5, which shows common mode H2 results 501, 502, 503 for the first, second and third examples respectively.

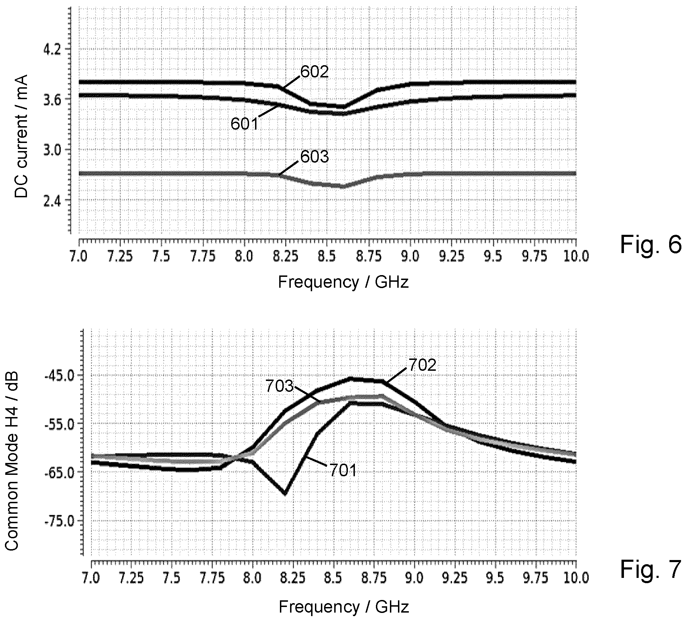

Figure 6 illustrates plots of DC current 601, 602, 603 as a function of frequency for the first, second and third examples respectively. Figure 7 illustrates plots of common mode H4 701, 702, 703 as a function of frequency for the first, second and third examples respectively. The feedback arrangement described above is mainly responsible for the low common mode signal.

Advantages of the frequency doubler circuit according to the present disclosure include improved efficiency, for example in terms of conversion gain or DC power, a higher output impedance, an improved common mode performance, a robust behaviour over process nodes and compatibility with typical voltage supplies, for example with a 1.45 V supply. Applications of the circuit may for example include local oscillator generators for radar transceivers, in which high power efficiency and high design yield are particularly important.

From reading the present disclosure, other variations and modifications will be apparent to the skilled person. Such variations and modifications may involve equivalent and other features which are already known in the art of frequency multiplier circuits, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A frequency doubler circuit (100) comprising:
first and second input terminals (101, 102) for receiving an input voltage signal (IN+, IN-) at a first frequency;
a first pair of transistors (103a, 103b) connected between a supply line (104) and a first node (105), the first pair of transistors (103a, 103b) having gates AC coupled to the respective first and second input terminals (101, 102);
a second pair of transistors (106a, 106b) connected between a common line (107) and a second node (108), the second pair of transistors (106a, 106b) having gates AC coupled to the respective first and second input terminals (101, 102);
an output matching circuit (109) having first and second output terminals (110, 111) for providing an output voltage signal (OUT+, OUT-) at a second frequency;
an amplifier (117) having a first input connected to the output matching circuit (109), a second input connected to a target voltage input (118) and an output connected to provide a bias voltage to the gates of the first or second pairs of transistors (103a, 103b);
a first common gate transistor (112) connected between the first node (105) and a first input (113) of the output matching circuit (109); and
a second common gate transistor (114) connected between the second node (108) and a second input (115) of the output matching circuit (109).

2. The frequency doubler circuit (100) of claim 1, wherein the first pair of transistors (103a, 103b) comprise first and second p-channel MOSFETs, a drain of the first p-channel MOSFET connected to a drain of the second p-channel MOSFET and a source of the first p-channel MOSFET connected to a source of the second p-channel MOSFET.

3. The frequency doubler circuit (100) of claim 2, wherein the drains of the first pair of transistors (103a, 103b) are connected to the first node (105) and the sources of the first pair of transistors (103a, 103b) are connected to the supply line (104).

4. The frequency doubler circuit (100) of claim 2 or claim 3, wherein the first common gate transistor (112) is a third p-channel MOSFET having a gate connected to a first common gate signal input (120).

5. The frequency doubler circuit (100) of any preceding claim, wherein the second pair of transistors (106a, 106b) comprise first and second n-channel MOSFETs, a drain of the first n-channel MOSFET connected to a drain of the second n-channel MOSFET and a source of the first n-channel MOSFET connected to a source of the second n-channel MOSFET.

6. The frequency doubler circuit (100) of claim 5, wherein the drains of the second pair of transistors (106a, 106b) are connected to the second node (108) and the sources of the second pair of transistors (106a, 106b) are connected to the common line (107).

7. The frequency doubler circuit (100) of claim 5 or claim 6, wherein the second common gate transistor (114) is a third n-channel MOSFET having a gate connected to a second common gate signal input (121).

8. The frequency doubler circuit (100) of any preceding claim, wherein the output matching circuit (109) comprises a transformer having a centre tap (116) connected between the first and second inputs (113, 115) of the output matching circuit (109).

9. The frequency doubler circuit (100) of claim 8, wherein the first input of the amplifier (117) is connected to the centre tap (116) and the output (119) of the amplifier (117) is connected to provide the bias voltage to the gates of the first pair of transistors (103a, 103b) via respective first and second biasing resistors (122, 123).

10. The frequency doubler circuit (100) of claim 8, wherein the first input of the amplifier (117) is connected to the centre tap (116) and the output (119) of the amplifier (117) is connected to provide the bias voltage to the gates of the second pair of transistors (106a, 106b) via respective first and second biasing resistors (122, 123).

11. The frequency doubler circuit (100) of claim 9, comprising a bias voltage input (127) connected to provide a bias voltage to the gates of the second pair of transistors (106a, 106b) via respective third and fourth biasing resistors (124, 125).

12. The frequency doubler circuit (100) of claim 10, comprising a bias voltage input (279) connected to provide a bias voltage to the gates of the first pair of transistors (103a, 103b) via respective third and fourth biasing resistors (124, 125).

13. The frequency doubler circuit (100) of any preceding claim, wherein the gates of the first pair of transistors (103a, 103b) and the gates of the second pair of transistors (106a, 106b) are each AC coupled to the respective first and second input terminals (101, 102) via a capacitor or a transformer.

14. A method of operating a frequency doubler circuit (100), the frequency doubler circuit (100) comprising:
first and second input terminals (101, 102) for receiving an input voltage signal (IN+, IN-) at a first frequency;
a first pair of transistors (103a, 103b) connected between a supply line (104) and a first node (105), the first pair of transistors (103a, 103b) having gates AC coupled to the respective first and second input terminals (101, 102);
a second pair of transistors (106a, 106b) connected between a common line (107) and a second node (108), the second pair of transistors (106a, 106b) having gates AC coupled to the respective first and second input terminals (101, 102);
an output matching circuit (109) having first and second output terminals (110, 111) for providing an output voltage signal (OUT+, OUT-) at a second frequency;
an amplifier (117) having a first input connected to the output matching circuit (109), a second input connected to a target voltage input (118) and an output connected to provide a bias voltage to the gates of the first or second pairs of transistors (103a, 103b);
a first common gate transistor (112) connected between the first node (105) and a first input (113) of the output matching circuit (109); and
a second common gate transistor (114) connected between the second node (108) and a second input (115) of the output matching circuit (109),
the method comprising:
providing an input voltage signal (IN+, IN-) at the first frequency at the first and second input terminals (101, 102);
providing bias voltage signals to the gates of the first and second pairs of transistors (103a, 103b, 106a, 106b) and the gates of the first and second common gate transistors (112, 114); and
providing an output voltage signal (OUT+, OUT-) at the first and second output terminals (110, 111) at a second frequency double the first frequency.

15. The method of claim 14, wherein the output matching circuit (109) comprises a transformer having a centre tap (116) connected between the first and second inputs (113, 115) of the output matching circuit (109), the first input of the amplifier (117) is connected to the centre tap (116) and the output (119) of the amplifier (117) is connected to provide the bias voltage to the gates of the first or second pairs of transistors (103a, 103b) via respective biasing resistors (122, 123), the method comprising providing the target voltage to the second input (118) of the operational amplifier (117), the target voltage being optionally half that of a supply voltage provided at the supply line (104).

## Amended claims

### Amended claims in accordance with Rule 137(2) EPC.

1. A frequency doubler circuit (100) comprising:
first and second input terminals (101, 102) for receiving an input voltage signal (IN+, IN-) at a first frequency;
a first pair of transistors (103a, 103b) connected between a supply line (104) and a first node (105), the first pair of transistors (103a, 103b) having gates AC coupled to the respective first and second input terminals (101, 102);
a second pair of transistors (106a, 106b) connected between a common line (107) and a second node (108), the second pair of transistors (106a, 106b) having gates AC coupled to the respective first and second input terminals (101, 102);
an output matching circuit (109) having first and second output terminals (110, 111) for providing an output voltage signal (OUT+, OUT-) at a second frequency;
an amplifier (117) having a first input connected to the output matching circuit (109), a second input connected to a target voltage input (118) and an output connected to provide a bias voltage to the gates of the first or second pairs of transistors (103a, 103b) via respective first and second biasing resistors (122, 123);
a first common gate transistor (112) connected between the first node (105) and a first input (113) of the output matching circuit (109); and
a second common gate transistor (114) connected between the second node (108) and a second input (115) of the output matching circuit (109);
wherein the output matching circuit (109) comprises a transformer having a centre tap (116) connected between the first and second inputs (113, 115) of the output matching circuit (109), and the first input of the amplifier (117) is connected to the centre tap (116).

2. The frequency doubler circuit (100) of claim 1, wherein the first pair of transistors (103a, 103b) comprise first and second p-channel MOSFETs, a drain of the first p-channel MOSFET connected to a drain of the second p-channel MOSFET and a source of the first p-channel MOSFET connected to a source of the second p-channel MOSFET.

3. The frequency doubler circuit (100) of claim 2, wherein the drains of the first pair of transistors (103a, 103b) are connected to the first node (105) and the sources of the first pair of transistors (103a, 103b) are connected to the supply line (104).

4. The frequency doubler circuit (100) of claim 2 or claim 3, wherein the first common gate transistor (112) is a third p-channel MOSFET having a gate connected to a first common gate signal input (120).

5. The frequency doubler circuit (100) of any preceding claim, wherein the second pair of transistors (106a, 106b) comprise first and second n-channel MOSFETs, a drain of the first n-channel MOSFET connected to a drain of the second n-channel MOSFET and a source of the first n-channel MOSFET connected to a source of the second n-channel MOSFET.

6. The frequency doubler circuit (100) of claim 5, wherein the drains of the second pair of transistors (106a, 106b) are connected to the second node (108) and the sources of the second pair of transistors (106a, 106b) are connected to the common line (107).

7. The frequency doubler circuit (100) of claim 5 or claim 6, wherein the second common gate transistor (114) is a third n-channel MOSFET having a gate connected to a second common gate signal input (121).

8. The frequency doubler circuit (100) of any preceding claim, wherein the output (119) of the amplifier (117) is connected to provide the bias voltage to the gates of the first pair of transistors (103a, 103b).

9. The frequency doubler circuit (100) of any of claims 1 to 7 8, the output (119) of the amplifier (117) is connected to provide the bias voltage to the gates of the second pair of transistors (106a, 106b) .

10. The frequency doubler circuit (100) of claim 8, comprising a bias voltage input (127) connected to provide a bias voltage to the gates of the second pair of transistors (106a, 106b) via respective third and fourth biasing resistors (124, 125).

11. The frequency doubler circuit (100) of claim 9, comprising a bias voltage input (279) connected to provide a bias voltage to the gates of the first pair of transistors (103a, 103b) via respective third and fourth biasing resistors (124, 125).

12. The frequency doubler circuit (100) of any preceding claim, wherein the gates of the first pair of transistors (103a, 103b) and the gates of the second pair of transistors (106a, 106b) are each AC coupled to the respective first and second input terminals (101, 102) via a capacitor or a transformer.

13. A method of operating a frequency doubler circuit (100), the frequency doubler circuit (100) comprising:
first and second input terminals (101, 102) for receiving an input voltage signal (IN+, IN-) at a first frequency;
a first pair of transistors (103a, 103b) connected between a supply line (104) and a first node (105), the first pair of transistors (103a, 103b) having gates AC coupled to the respective first and second input terminals (101, 102);
a second pair of transistors (106a, 106b) connected between a common line (107) and a second node (108), the second pair of transistors (106a, 106b) having gates AC coupled to the respective first and second input terminals (101, 102);
an output matching circuit (109) having first and second output terminals (110, 111) for providing an output voltage signal (OUT+, OUT-) at a second frequency;
an amplifier (117) having a first input connected to the output matching circuit (109), a second input connected to a target voltage input (118) and an output connected to provide a bias voltage to the gates of the first or second pairs of transistors (103a, 103b);
a first common gate transistor (112) connected between the first node (105) and a first input (113) of the output matching circuit (109); and
a second common gate transistor (114) connected between the second node (108) and a second input (115) of the output matching circuit (109),
the method comprising:
providing an input voltage signal (IN+, IN-) at the first frequency at the first and second input terminals (101, 102);
providing bias voltage signals to the gates of the first and second pairs of transistors (103a, 103b, 106a, 106b) and the gates of the first and second common gate transistors (112, 114); and
providing an output voltage signal (OUT+, OUT-) at the first and second output terminals (110, 111) at a second frequency double the first frequency;
wherein the output matching circuit (109) comprises a transformer having a centre tap (116) connected between the first and second inputs (113, 115) of the output matching circuit (109), the first input of the amplifier (117) is connected to the centre tap (116) and the output (119) of the amplifier (117) is connected to provide the bias voltage to the gates of the first or second pairs of transistors (103a, 103b) via respective biasing resistors (122, 123), the method comprising providing the target voltage to the second input (118) of the operational amplifier (117), the target voltage being optionally half that of a supply voltage provided at the supply line (104).
